# EUROPEAN PATENT SPECIFICATION

(11) **EP 0 255 772 B1**
(45) Date of publication and mention of the grant of the patent: **10.03.1993**
(21) Application number: 87306566.8
(22) Date of filing: 24.07.1987
(51) Int. Cl.: G01R 7/08, G01R 5/16

(54) **Instrument with crossed-coil type movable magnet**
Instrument mit beweglichem Magneten der Querspulenart
Instrument avec aimant mobile du type à enroulement croisé

(30) Priority: 31.07.1986 JP 180920/86; 30.05.1987 JP 136386/87
(43) Date of publication of application: 10.02.1988
(73) Proprietor: Nippon Seiki Co. Ltd., Nagaoka-city Niigata-pref (JP)
(72) Inventor: Tanaka, Seizou, Nagaoka Niigata-ken, 940 (JP); Ando, Ryuichi, Nagaoka Niigata-ken, 940 (JP)
(74) Representative: Votier, Sidney David

(56) References cited:
- DE-A- 2 035 164
- DE-A- 3 011 013
- FR-A- 2 508 176
- GB-A- 2 045 953
- US-A- 3 636 447
- US-A- 3 946 311
- PATENT ABSTRACTS OF JAPAN, vol. 8, no. 153 (P-287)[1590], 17th July 1984; & JP-A-59 51 362

## Description

### BACKGROUND OF THE INVENTION

### Field of the Invention

The present invention relates to a general purpose instrument with a cross-coil type movable magnet to be used, for example, in a fuel meter or a thermometer of a vehicle.

### Description of Prior Art

In an instrument with a cross-coil type movable magnet including a pointer needle shaft, a movable magnet rotating about the pointer needle shaft is located in a bobbin, and crossed coils crossing each other are wound on the bobbin so that a measured value or the like obtained from an object to be measured is converted into an electric signal and a current corresponding to the electric current is applied to the crossed coils. This causes magnetic fields to be generated, and the movable magnet is rotated in a direction of the composite magnetic field of the crossed coils, which turns the pointer needle shaft to point to a measured value.

If electric current flow direction through each of the crossed coils is variable, the direction of the composite magnetic field can be arranged with any angle through an arc of 360°. In practice, however, when the instrument is mounted on a vehicle or the like, the directions of application of electric currents to the crossed coils are fixed because a direct-current (DC) power supply, such as a secondary cell or an accumulator, is used as the power supply for the instrument, which limits the range of rotation of the pointer needle shaft to the range of the crossing angle between the crossed coils. To overcome this difficulty, there have been proposed various methods to improve the instrument with a crossed-coil type movable magnet to provide an indication through a wider angle.

One of the proposals is described in US-A-3 636 447 and in Japanese Patent Laid-Open No. 46-6091 in which by use of means for converting an input from a measurement object into a DC signal and for inverting a DC signal exceeding a predetermined value, one of the crossed coils is supplied with an output current that develops one cycle of a substantially sinusoidal signal and the other of the crossed coils is supplied with an output current that develops one cycle of a substantially cosinusoidal signal, as the input quantity increases from the minimum value to the maximum value.

In addition, as described in US-A-3 946 311 and Japanese Patent Laid-Open No. 50-34255, there exists a method in which an input signal is received and is supplied to a plurality of pulse generators, which generate a plurality of pulse signals to be used to control a switch means disposed between the pulse generators and the crossed coils.

Moreover, in a method described in Japanese Patent Laid-Open No. 51-131357, the crossed coil unit does not comprise two coils crossing each other at a right angle therebetween but includes three coils in respective directions, and an electric signal corresponding to the input quantity is supplied by the use of two adjacent coils as a pair.

The prior art examples described above are respectively attended with disadvantages. Namely, in the method using the means to invert the DC signal and to supply a substantially sinusoidal signal and a substantially cosinusoidal signal to the respective crossed coils, since current having a characteristic of a direct current is supplied, power loss takes place at an output section, which leads to heat generation. Moreover, since the output characteristic of the pointer needle shaft is fixed, it is difficult to select a display dial or scale plate most suitable for an instrument to be adopted.

Furthermore, in the method in which an input is converted into a plurality of pulse signals and the crossed coils are supplied with pulse signals undergoing switch control, since the current flows through the coils intermittently, the pointer needle shaft undesirably oscillates when the input quantity is small.

Next, in the method using three crossed-coils, the manufacturing process of the coils is much more complicated as compared with two crossed-coils and hence the cost soars.

GB-A-2 045 953 discloses an air core gauge having quadrature coils wherein a first coil is driven by a constant reference current and a second coil is driven by a current which varies as a tangent function in order to drive a needle through different indicating octants.

The present invention is characterised in that said means for generating said current pulses include means for generating and counting clock pulses depending on the magnitude of the input parameter, said means including an arithmetic processor, which responds to the clock pulse count in order to compute values which are used to develop either piecewise linear approximations of, or pure sinusoidal and cosinusoidal waveforms, said waveforms having periods corresponding to the clock pulse count,
said current pulses, derived from said waveforms, have constant high or low values and variable durations, and
said switching means selectively applies said current pulses to different ends of said X and Y coils in said crossed-coil unit so as to adjust the quadrant of said vector; the resultant vector, in the selected quadrant, being determined by the pulse duration.

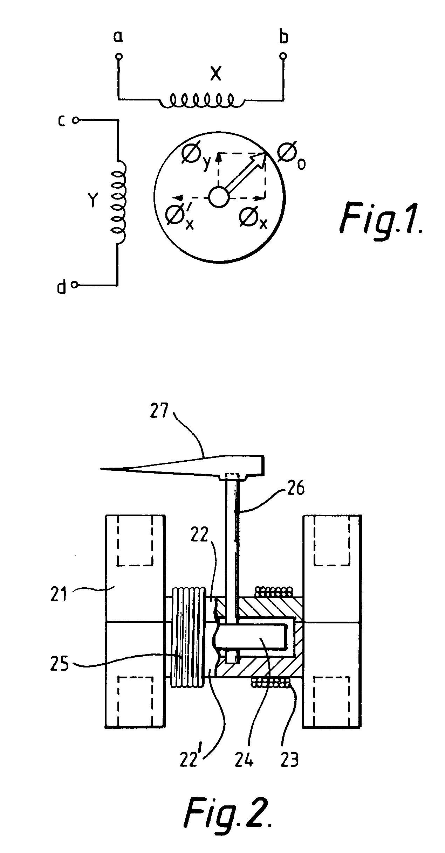

Consequently, referring now to a simplified diagram of FIG. 1, when an input quantity is received, current flow direction current is determined for each of coils X and Y according to the magnitude of the input quantity. For example, a direction a ----> b and a direction c ---->d are respectively determined for the coils X and Y, and the time for supplying the current is also determined for each of the coils X and Y in accordance with the magnitude of the input quantity. When pulse signals with predetermined potential values flow through the coils X and Y for respective predetermined periods of time, the movable magnet turns in the direction of the composite magnetic field Φ ₀ resultant from the magnetic fields Φ_{X} and Φ_{Y} generated by the coils X and Y, respectively. This enables the pointer needle to indicate the input quantity, namely, information associated with the measurement object. Moreover, as the input quantity changes and the directions for supplying the currents become different from those described above, for example when the direction for supplying the electric current to the coil X is set to the direction b ----> a, the direction of the magnetic field Φʹ_{X} generated by the coil X becomes opposite to that of the magnetic field Φ_{X} generated in the preceding condition and the position to which the pointer needle points is determined by both current flow directions and time durations in each coil.

Thus, with the provision of an instrument driving mechanism in which the directions for supplying the currents to the coils X and Y can be set according to the input quantity, there is provided a moving-magnetic-type instrument capable of effecting a 360° indication by controlling both the duration and direction of current applied to each coil of a cross-coil unit. In addition, according to the present invention, since a DC pulse signal set independently of the input quantity is applied to the coils, the circuit develops almost no electric loss and heat generation is prevented so that the circuit can be miniaturized. Moreover, disadvantages such as oscillation of the pointer needle in response to a low input quantity cannot take place.

Still other objects and advantages of the present invention will become readily apparent to those skilled in this art from the following detailed description, wherein only the preferred embodiment of the invention are shown and described, simply by way of illustration of the best mode contemplated of carrying out the invention. As will be realized, the invention is capable of other and different embodiments, and its several details are capable of modifications in various obvious respects, all without departing from the invention. Accordingly, the drawing and description are to be regarded as illustrative in nature, and not as restrictive.

### Brief Description of the Drawings

The present invention will be apparent from the following detailed description taken in conjunction with the accompanying drawings in which:
FIG. 1 is an explanatory diagram illustrating operations of an instrument with a crossed-coil movable magnet of a type to which the invention is directed;
FIG. 2 is a front view of a portion of the instrument showing the instrument movement;
FIG. 3 is a schematic block diagram of circuitry for driving the crossed-coils using an arithmetic processor unit in accordance with the preferred embodiment of the invention with coil driving switches shown in symbolic form;
FIG. 4 is a flow chart broadly describing the operation of the arithmetic processor of FIG.3;
FIG. 5 is a flow chart describing an alternative to FIG. 4 wherein the period of input pulses is determined to obtain the value of an input parameter being measured;
FIG. 6(a) and FIG. 6(b) show gating and clock pulse waveforms, respectively, to help describe an alternative method of measuring an input parameter;
FIG. 7 is a detailed flow chart showing how the arithmetic processor of FIG. 3 generates sinusoidal and cosinusoidal waveforms in the form of piecewise linear approximations, to drive the crossed-coils;
FIG. 8 is a diagram of piecewise linear approximations of sinusoidal and cosinusoidal waveforms developed in accordance with the flow chart of FIG. 7;
FIG. 9 is a flow chart showing how the arithmetic processor of FIG. 3 develops sinusoidal and cosinusoidal waveforms using linear, rather than piecewise linear, processing;
FIG. 10 is a flow chart showing how the arithmetic processor of FIG. 3 drives the crossed-coils as a function of the input parameter being measured;
FIG. 11 is a block diagram of an alternative gating circuit; and

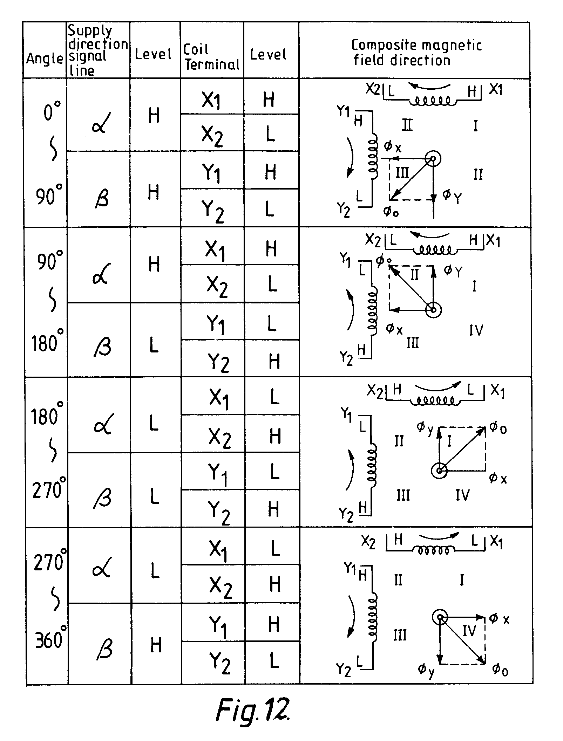

FIG. 12 is a table showing how composite magnetic flux and coil current flow directions are related.

### Best Mode for Practicing the Invention

Referring to FIG. 2, a pointer movement of a type to which the invention is applied, comprises a upper frame 22 and a lower frame 22' disposed with a mounting base 21 at each of four corners thereof, combined to form a bobbin 23. A movable magnet 24 is installed in the bobbin 23 so as to be arbitrarily rotatable therein. Crossed-coil unit 25, comprising a coil X and a coil Y (FIG. 1) is wound on external surfaces of frames 22-22ʹ. A pointer needle shaft 26 is separately linked to the movable magnet 24, with the shaft 26 being disposed to extend from the upper frame 22. A pointer needle 27 is mounted on the shaft 26.

In accordance with the preferred embodiment of this invention, the coils X and Y of crossed-coil unit 25 are driven selectively with currents having controllable flow directions and durations, responsive to an input parameter being measured, to rotate movable magnet 25, shaft 26 and pointer needle 27 throughout a 360° arc of rotation.

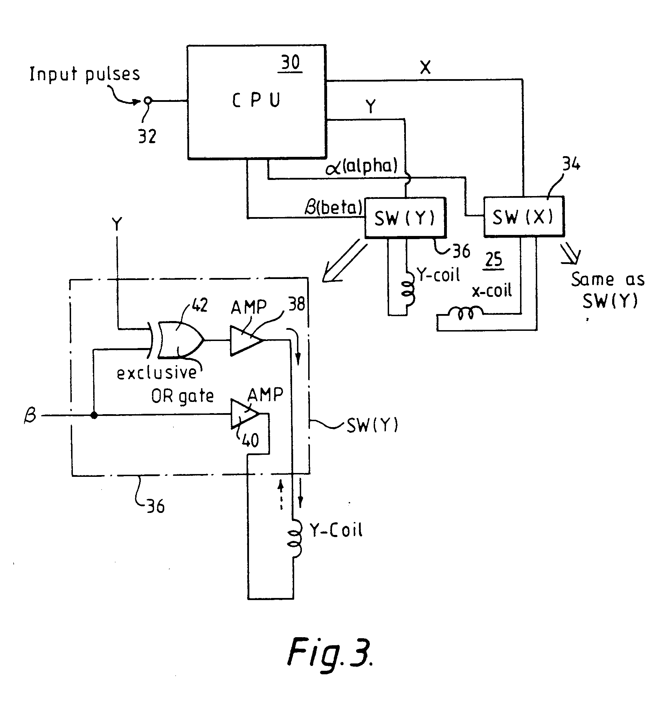

In the preferred embodiment of the invention, shown in FIG. 3, coils X and Y of the crossed-coil unit 25 are driven respectively by an arithmetic processor 30 in response to an input parameter in the form of input pulses at input terminal 32. The input pulses have a pulse repetition rate corresponding to the magnitude of the input parameter. In this example, it will be assumed that the input pulses are generated by a tachometer and are representative of engine speed, although it will be apparent that any other type of input parameter could be measured as well in accordance with the principles of this invention.

The processor 30 is programmed to control switches SW(X) and SW(Y), identified by 34, 36 in Fig. 3, and to control the directions of flow and durations of the high and low current pulses which are applied to coil X and coil Y of crossed-coil unit 25. Based upon the magnitude of the input parameter, the directions of current flow in the two coils establish the quadrant of arc within which the needle pointer swings, and the frequency or period of the current applied to the two coils determines the location of the pointer within each quadrant.

The directions of current flow in the two coils X and Y of the crossed-coil 25 are determined by the states of output lines alpha and beta of arithmetic processor 30. For example, with reference to FIG. 13, to position pointer needle 27 into quadrant III of the output of the instrument, representing an arc of rotation of needle pointer 27 within the range of 180° and 270°, current is controlled to flow from terminal X₁ to terminal X₂ of coil X and from terminal Y₁ to terminal Y₂ of coil Y. This is carried out by switches 34 and 36 in response to logic high states at processor output lines alpha and beta. Similarly, the needle pointer 27 is positioned within quadrants I, II and IV by applying currents to coils X and Y in the directions shown in FIG. 13 in response to the logic states of the lines alpha and beta.

The direction of current flow in each coil is controlled by switches 34, 36 as follows with reference to FIG. 3 showing switch 36 in a symbolic form. Considering for this example coil Y, when a logic high state on line beta is applied to switch 36, current flows via amplifier 38 through the coil Y in the direction shown by the solid arrow in FIG. 3, and alternatively, when line beta is at a logic low state, the switch 36 applies via amplifier 40 a driving current through coil Y in the opposite direction, indicated by dashed arrows. Similarly, although not shown, the logic state of line alpha applied to switch 34, controls current flow direction in coil X.

The directions of flow of current in the coils X and Y establish the quadrant within which needle pointer 27 is moved, as described, and the position of the pointer within the quadrant, determined by the duration of current flow in the coils, is controlled by the logic state of processor output lines X, Y which correspond respectively to the coils X, Y of crossed-coil unit 25.

The amplifiers 38, 40 are controlled by an Exclusive OR gate 42 having one input connected to current flow direction control line alpha or beta and the other input connected to time duration control line X or Y. An Exclusive OR circuit by definition has an output that is at a logic high state only if the logic states of the input terminals of the gate are different from each other. Accordingly, current in each coil X, Y having flow in either direction flows only for a time duration determined by the logic state on line X or line Y. For example, when line beta is at a logic high state and line Y is at a logic low state, the output of gate 42 is at a logic high state since the input states are different from each other, and current in coil X flows in the direction of the solid arrow. However, when the state of line Y changes to a logic high state, because the input logic states are now the same, the output of the gate 42 switches to a logic low state to terminate current flow in coil Y. The duration of current flow in coil Y is therefore controlled by the state of the processor output line Y. Similar commentary applies to processor output lines alpha and X and switch 24 to control the direction and duration of current flow in coil X.

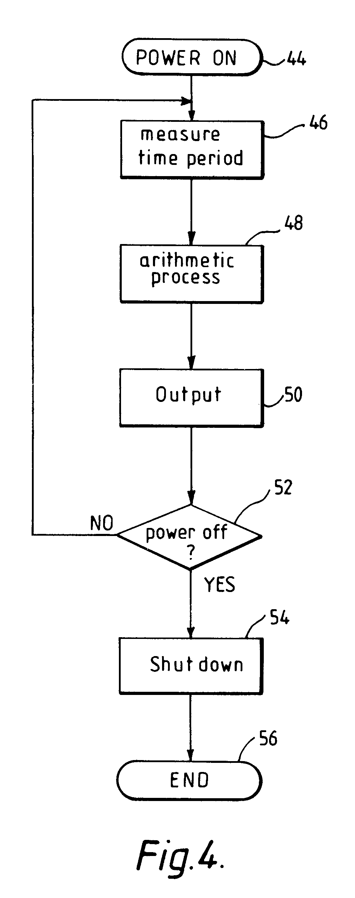

In accordance with the embodiment of Figure 3, the durations of current flow in coils X and Y controlled by processor output lines X and Y are established by the period of sinusoidal and cosinusoidal waveforms developed by the arithmetic processor 30 in response to the magnitude of the input parameter being measured. Thus, with reference to Fig. 4, processor 30 is programmed to carry out the sequence of functions set forth broadly in the flow chart therein, wherein following initiation of power to the instrument (step 44), the input parameter is measured by determining the period of pulses received in input terminal 32 (step 46) and carrying out an arithmetic process (step 48) to develop sinusoidal and cosinusoidal waveforms having periods corresponding to the measured input parameter. Currents having high and low values, as explained above are applied to the coils X and Y (step 50), and when power is subsequently removed (step 52), a conventional shutdown sequence (step 54) is carried out to ready the instrument to be again turned on (step 56).

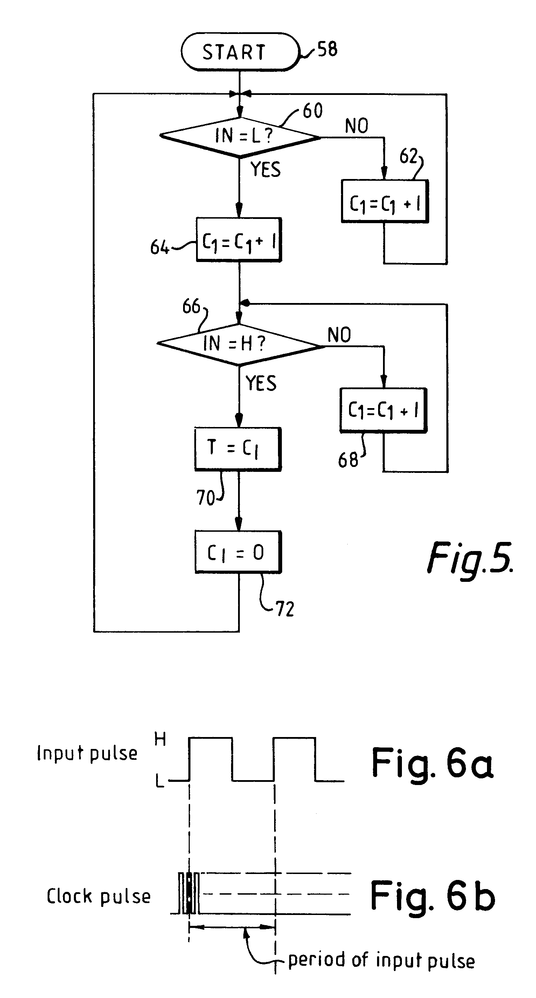

Step 46, shown in detail in the flow chart of FIG. 5, measures the period between successive pulses to determine, indirectly, the input pulse repetition rate. The routine described in FIG. 5, upon execution (step 58), monitors the state of the input terminal 32 to detect the presence of a pulse. When the input terminal 32 has a logic high state, indicating the presence of a pulse, a counter, implemented by software in CPU 30, increments at the system clock rate (step 62). When input terminal 32 switches to a logic low state, indicating that no pulse currently is at the input terminal, the counter increments (step 64). In step 66, with the input terminal still at a logic low state the counter continues to increment, at the system clock rate (step 68), until the state of input terminal 32 returns to a logic high state, indicating completion of an input pulse cycle. The accumulated count is stored (step 70), and the counter is reset (step 72). The stored count represents the period of the input pulses, to be applied to synthesize sinusoidal and cosinusoidal waveforms in the arithmetic processor 30.

It should be recognized that the frequency, rather than the period, of the input pulses can alternatively be measured, for processing by processor 30 to develop the required sinusoidal and cosinusoidal waveforms. Thus, with reference to FIGS. 6(a) and 6(b), the processor 30 may, if desired, be programmed to establish fixed gating periods, shown in FIG. 6(a), within which the input pulses are counted. In this example, although not shown, a counter responsive to pulses at input terminal 32 is controlled by gating the counter on and off using the fixed duration signals of FIG. 6(a), determined arbitrarily.

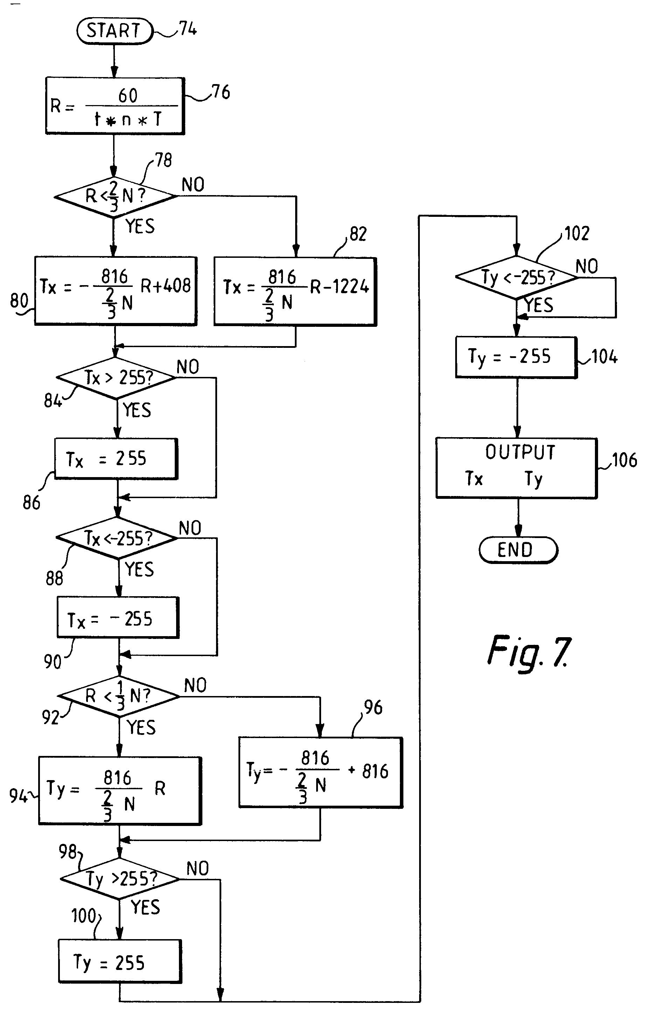

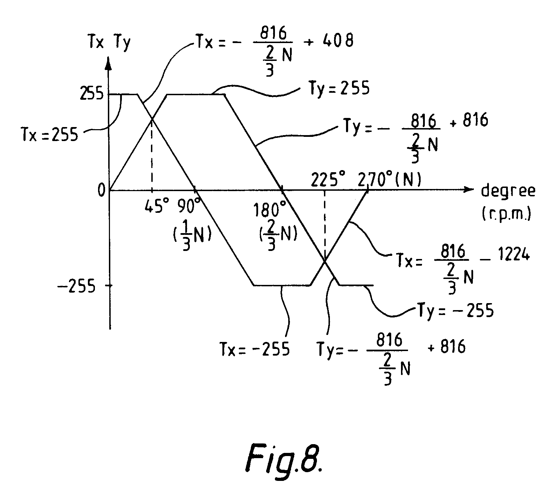

With reference to FIG. 7, an algorithm carried out by the flow chart shown therein synthesizes the sinusoidal and cosinusoidal waveforms of FIG. 8, wherein the waveforms are piecewise linear approximations of sinusoidal and cosinusoidal waveforms. In the flow chart of FIG. 7 and waveforms of FIG. 8, the symbols are identified as follows:
- t:: system clock time period
- n:: number of pulses generated per each revolution of an engine, e.g. n =2 in a four cycle, four cylinder engine.
- R:: number of engine revolutions (RPM)
- T:: pulse period developed by flow chart of FIG. 6
- Tx:: time duration of current applied to coil X
- Ty:: time duration of current applied to coil Y
- N:: speed of engine, in RPM, when the needle pointer is at full scale, e.g. 270°

Thus, with more detailed attention to FIGS. 7 and 8, upon execution of the routine shown in FIG. 7 (step 74), the number of engine revolutions R is calculated as a function of the number of pulses per revolution of the engine, n, the measured pulse period T and the system clock period t (step 76). If the number of engine revolutions per minute (RPM) calculated in step 76 is less than two-thirds full scale (step 78), the processor 30 develops a line segment defined by step 80 (see also FIG. 8) having a negative slope; if engine RPM is greater than two-thirds full range RPM, on the other hand, the processor 30 develops a line segment defined by step 82 and having a positive slope, shown in FIG. 8. Steps 84, 86, 88 and 90 clamp the sinusoidal waveform to peak values of 255 and -255, shown in FIG. 8 to complete a synthesized sinusoidal waveform. The quantity 255 is selected for convenience, i.e., it represents the decimal value of the capacity of an eight bit converter.

Similarly, steps 92, 94, 96, 98, 100, 102 and 104 develop the piecewise linear approximation of a cosinusoidal waveform, as shown in FIG. 8, clamped between the upper and lower limits defined by the quantity (absolute value) 255.

The constants which define the amplitude and slopes defining the piecewise linear sinusoidal and cosinusoidal waveforms of FIG. 8 are determined arbitrarily in accordance with particular circuit and parametric requirements in this example; however, appropriate constants will be developed by persons skilled in the art depending upon applicable circuit and parametric requirements. The sinusoidal and cosinusoidal waveforms thus developed are made available as control signals Tx and Ty, respectively, in step 106.

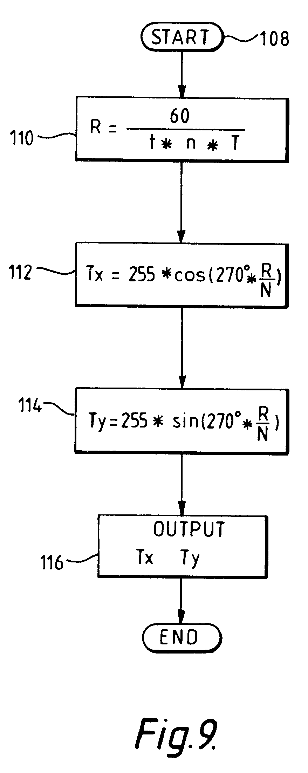

Alternatively, the arithmetic processor 30 may be programmed to develop pure sinusoidal and cosinusoidal waveforms, i.e., without undergoing calculation of piecewise linear approximations. Thus, with reference to FIG. 9, an alternative routine may be executed at step 108 to measure engine RPM R (step 110) in a similar manner as carried out in step 76. Steps 112 and 114 compute the sinusoidal and cosinusoidal waveforms by computing values of the respective trigonometric functions, to be made available as an output signal (step 116) to drive coils X and Y.

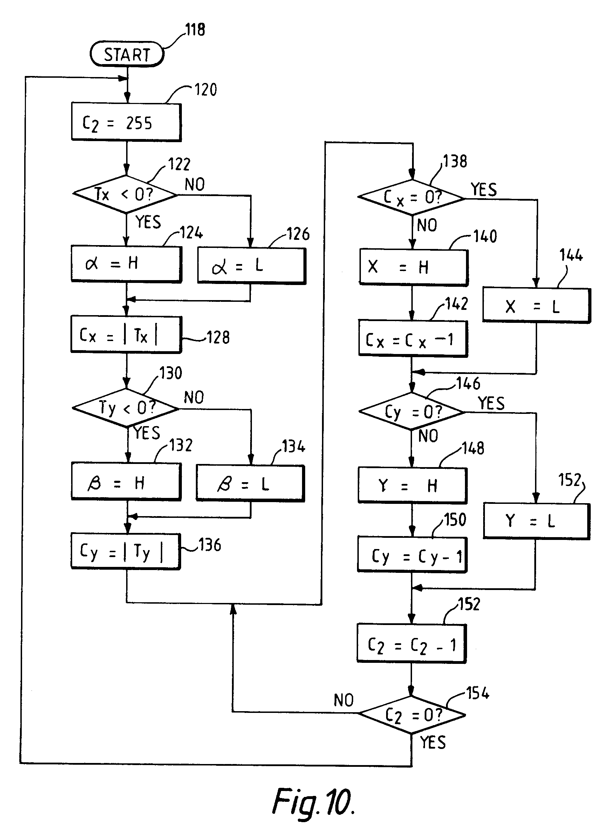

In either case, the output routine 50 of FIG. 4 is provided by the routine shown in FIG. 10, wherein, upon execution (step 118), a counter C₂ is preset to 255 corresponding to the maximum value of an 8 bit binary counter (step 120). If the value of Tx is less than zero, the processor output line alpha is set at a logic high state; otherwise, the line is set at a logic low state (steps 122, 124, 126). Another counter Cx is preset at the magnitude of Tx determined in FIG. 7 or in FIG. 9 (step 128).

If the value of current Ty to be applied to coil Y is less than zero (step 130), the processor output line beta is set at a logic high state (step 132); otherwise, the line is set to a logic low state (step 134). A counter Cy is now set to the value of current Ty to be applied to coil Y (step 136).

Assuming that the count in counter Cx is not zero (step 138), the current direction control line X is set at a logic high state (step 140) and the count in counter Cx is decremented (step 142). If the content of the counter Cx (step 138) is zero, on the other hand, the control line X is set at a logic low state (step 144).

Similarly, assuming that the count of counter Cy is not zero (step 144), the flow direction control line Y, for controlling the direction of current flow in coil Y, is set at a logic high state (step 148) and the count of counter Cy is decremented (step 150). On the other hand, if the content of counter Cy is zero, in step 146, the current flow direction flow line Y is set at a logic low state (step 152).

The content of counter C₂ is decremented (step 152) and if the counter has not yet counted down to zero (step 154), steps 138-154 are repeated; otherwise, the program returns to step 120.

Thus, the direction of current flow in each coil is established by testing the polarities of currents to be applied to coils X and Y during successive fixed periods consisting of 255 system clock counts preset in step 120. During each such period, the state of lines X and Y are controlled to energize the two coils X and Y for time durations determined by the piecewise linear or pure sinusoidal waveforms obtained in Figs. 7 and 9.

There has accordingly been described an embodiment of the apparatus for increasing the range of the pointer needle of a crossed-coil instrument movement, wherein both the duration and direction of current applied to each coil of the crossed-coil unit are controlled as a function of an input parameter, e.g., engine speed, measured from a measurement object, e.g. engine tachometer. The composite flux developed by the flux generated by each coil as a result of currents applied thereto, in accordance with the invention, drives the pointer needle through a substantially wider range than heretofore possible.

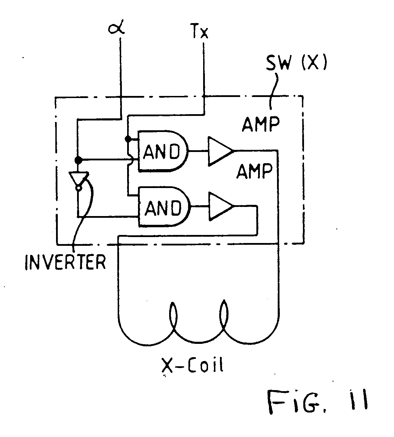

In this disclosure, there is shown and described only the preferred embodiment of the invention, but, as aforementioned, it is to be understood that the invention is capable of use in various other combinations and environments and is capable of changes or modifications within the scope of the inventive concept as expressed herein. Fig. 11 illustrates an alternative gating circuit for control switches SW(Y) and SW(X), identified by 34 and 36 in Fig. 3.

## Claims

1. A crossed-coil type instrument comprising a crossed-coil unit (25) which includes X and Y coils, a needle shaft (26) rotated by a movable magnet (24) within said unit (25); input means (32) for receiving an input electrical parameter; means (30) for generating current pulses which are applied to said crossed-coil unit (25), in the form of a resultant vector, so as to cause said unit (25) to measure and to indicate the magnitude of said input parameter; and switching means (34, 36) for applying said pulses to said X and Y coils,
characterised in that
said means (30) for generating said current pulses include means for generating and counting clock pulses depending on the magnitude of the input parameter, said means (30) including an arithmetic processor, which responds to the clock pulse count in order to compute values which are used to develop either piecewise linear approximations of, or pure, sinusoidal and cosinusoidal waveforms, said waveforms having periods corresponding to the clock pulse count,
said current pulses, derived from said waveforms, have constant high or low values and variable durations, and
said switching means (34, 36) selectively applies said current pulses to different ends of said X and Y coils in said crossed-coil unit (25) so as to adjust the quadrant of said vector; the resultant vector, in the selected quadrant, being determined by the pulse duration.

2. A crossed-coil type instrument according to Claim 1, wherein said current pulses from said means (30) have logic high or low states (X, Y), said means (30) also providing current flow directional outputs (α, β) which are applied to said switching means (34, 36) for controlling the selected application of said pulses to different ends of said X and Y coils.

3. A crossed-coil type instrument wherein said means (30) includes first counting means (C₂) in which a preset count is stored corresponding with a maximum for said current durations, and second counting means (Cx, Cy) for storing the values representing variable parameters (Tx, Ty) which are developed from said piecewise linear approximations or pure sinusoidal and cosinusoidal waveforms, said second counting means being periodically renewed and cyclically counted down so that said logic high or low states are provided until the variable parameters (Tx, Ty) have been reduced to zero.

4. A crossed-coil type instrument according to Claim 3 wherein said means (30) resolves said current flow directional outputs (α, β) according to whether said variable parameters (Tx, Ty) are plus or minus.

5. A crossed-coil type instrument according to Claim 2, wherein each of said switching means (34, 36) comprises logical gating means (42, Fig. 3; or Fig. 11) having inputs for receiving the respective logic state output (X, Y) and the respective current flow directional output (α, β), said logical gating means being connected to amplification means (AMP) which are connected to respective ends of the associated X or Y coil.

6. A cross-coil type instrument according to Claim 5, wherein said logical gating means is an exclusive OR gate (42), the output of said exclusive OR gate (42) being connected to a first amplifier (38); the respective current flow directional output (α, β) also being connected to a second amplifier (40); said first and second amplifiers (38, 40) being connected to respective ends of the associated X or Y coil.

## Patentansprüche

1. Kreuzspuleninstrument umfassend
- eine Kreuzspuleneinheit (25), die X- und Y-Spulen umfaßt,
- eine mittels eines beweglichen Magneten (24) innerhalb der Einheit (25) gedrehte Nadelwelle (26);
- Eingangsmittel (32) zum Empfangen eines elektrischen Eingabeparameters;
- Mittel (30) zum Erzeugen von Stromimpulsen, welche an die Kreuzspuleneinheit (25) in Form eines resultierenden Vektors angelegt werden, so daß die Einheit (25) die Größe des Eingabeparameters mißt und anzeigt; und
- Schaltmittel (34, 36) zum Anlegen der Impulse an die X- und Y-Spulen, **dadurch gekennzeichnet,**
daß die Mittel (30) zum Erzeugen der Stromimpulse Mittel zum Erzeugen und Zählen von Taktimpulsen in Abhängigkeit von der Größe des Eingabeparameters umfassen, wobei die Mittel (30) einen arithmetischen Prozessor umfassen, welcher auf den Taktimpulszählwert anspricht, um Werte zu berechnen, die dazu verwendet werden, entweder stückweise lineare Näherungen von sinus- und kosinusförmigen Wellenformen oder reine sinus- und kosinusförmige Wellenformen zu entwickeln, wobei die Wellenformen Perioden aufweisen, die dem Taktimpulszählwert entsprechen, und wobei die Stromimpulse, die von den Wellenformen abgeleitet werden, konstante hohe oder niedere Werte und veränderbare Zeitdauern aufweisen, und wobei ferner das Schaltmittel (34, 36) wahlweise die Stromimpulse an verschiedene Enden der X- und Y-Spulen in der Kreuzspuleneinheit (25) anlegt, um den Quadranten des Vektors einzustellen; wobei der resultierende Vektor in dem ausgewählten Quadranten durch die Impulszeitdauer bestimmt ist.

2. Kreuzspuleninstrument nach Anspruch 1, worin die Stromimpulse von dem Mittel (30) logische Hoch- oder Nieder-Zustände (X, Y) aufweisen, wobei die Mittel (30) ferner Stromflußrichtungsausgaben (α, β) vorsehen, welche an das Schaltmittel (34, 36) zum Steuern des ausgewählten Anlegens der Impulse an verschiedenen Enden der X- und Y-Spulen angelegt werden.

3. Kreuzspuleninstrument, worin das Mittel (30) erste Zählermittel (C2) umfaßt, in welchen ein einem Maximum der Stromzeitdauern entsprechender, voreingestellter Zählwert gespeichert ist, sowie zweite Zählermittel (Cx, Cy) zum Speichern der Werte, die variable Parameter (Tx, Ty) darstellen, welche von den stückweise linearen Näherungen oder den reinen sinusförmigen- und kosinusförmigen Wellenformen entwickelt werden, wobei die zweiten Zählermittel periodisch neu gesetzt und zyklisch abwärts gezählt werden, so daß die logischen Hoch- oder Nieder-Zustände vorgesehen sind, bis die variablen Parameter (Tx, Ty) auf Null reduziert worden sind.

4. Kreuzspuleninstrument nach Anspruch 3, worin das Mittel (30) die Stromflußrichtungsausgaben (α, β), abhängig davon ob die variablen Parameter (Tx, Ty) positiv oder negativ sind, bestimmt.

5. Kreuzspuleninstrument nach Anspruch 2, worin jedes der Schaltmittel (34,36) logische Gattermittel (42 in Fig. 2; oder Fig. 11) umfaßt, welche Eingangsanschlüsse zum Empfangen der jeweiligen Ausgaben des logischen Zustands (X,Y) sowie der jeweiligen Stromflußrichtungsausgaben (α,β) aufweisen, wobei die logischen Gattermittel mit Verstärkermitteln (Verstärker) verbunden sind, welche mit jeweiligen Enden der zugeordneten X- oder Y-Spule verbunden sind.

6. Kreuzspuleninstrument nach Anspruch 5, worin das logische Gattermittel ein Exklusiv-Oder-Gatter (42) ist, wobei der Ausgang des Exklusiv-Oder-Gatters (42) mit einem ersten Verstärker (38) verbunden ist, und wobei der jeweilige Stromflußrichtungsausgang (α,β) ebenso mit einem zweiten Verstärker (40) verbunden ist, und wobei ferner die ersten und zweiten Verstärker (38,40) mit jeweiligen Enden der zugeordneten X- oder Y-Spule verbunden sind;

## Revendications

1. Un instrument de type à bobines croisées (25) comportant un ensemble à bobines croisées (25), comprenant des bobines X et Y, un arbre porte-aiguille (26) entraîné à rotation par un aimant mobile (24) dans ledit ensemble (25); des moyens d'entrée (32) pour recevoir un paramètre d'entrée électrique; des moyens (30) pour émettre des impulsions de courant appliquées audit ensemble à bobines croisées (25) sous forme d'un vecteur résultant, de manière que ledit ensemble (25) mesure et indique l'amplitude dudit paramètre d'entrée; et des moyens de commutation (34, 36) pour appliquer lesdites impulsions auxdites bobines X et Y,
caractérisé en ce que
lesdits moyens d'émission desdites impulsions de courant (30) comprennent des moyens d'émission et de comptage des impulsions d'horloge en fonction de l'amplitude du paramètre d'entrée, lesdits moyens (30) comprenant un processeur arithmétique répondant au comptage des impulsions d'horloge afin de calculer les valeurs utilisées pour développer, soit des approximations linéaires successives soit des formes d'onde sinusoïdales et cosinusoïdales pures, les périodes desdites formes d'onde correspondant au comptage des impulsions d'horloge,
lesdites impulsions de courant, dérivées desdites formes d'ondes ont des valeurs haute et basse constantes et de durée variable, et
lesdits moyens de commutation (34, 36) appliquent sélectivement lesdites impulsions de courant à différentes extrémités desdites bobines X et Y dudit ensemble de bobines croisées (25), de manière à ajuster le quadrant dudit vecteur; le vecteur résultant, dans le quadrant choisi, étant déterminé par la durée de l'impulsion.

2. Un instrument à bobines croisées selon la revendication 1, dans lequel lesdites impulsions de courant émises par lesdits moyens (30) ont des états logiques haut et bas (X, Y), lesdits moyens (30) émettant également des courants de sortie directionnels (α, β ), appliqués auxdits moyens de commutation (34, 36) pour commander l'application choisie desdites impulsions aux différentes extrémités desdites bobines X et Y.

3. Un instrument à bobines croisées, dans lequel lesdits moyens (30) comprennent des premiers moyens de comptage (C2) dans lesquels un nombre compté prédéterminé est stocké et correspond à un maximum desdites durées de courant, et des seconds moyens de comptage (Cx, Cy) pour stocker les valeurs représentant les paramètres variables (Tx, Ty), développés à partir desdites approximations linéaires successives ou formes d'ondes sinusoïdales et cosinusoïdales pures, lesdits seconds moyens de comptage étant renouvelés périodiquement et décomptés cycliquement de manière à produire lesdits états logiques haut et bas, jusqu'à ce que les paramètres variables (Tx, Ty) aient été réduits à zéro.

4. Un instrument à bobines croisées selon la revendication 1, dans lequel lesdits moyens (30) résolvent lesdites sorties de courant directionnelles (α, β) suivant que lesdits paramètres variables (Tx, Ty) sont positifs ou négatifs.

5. Un instrument à bobines croisées selon la revendication 2, dans lequel chacun desdits moyens de commutation (34, 36) comprend des moyens à porte logique (42, Fig.3; ou Fig.11) comprenant des entrées pour recevoir la sortie d'état logique respective (X, Y) et la sortie de courant directionnel (α, β), lesdits moyens à porte logique étant reliés à des moyens d'amplification (AMP), reliés aux extrémités respectives de la bobine X ou Y associée.

6. Un instrument à bobines croisées selon la revendication 5, dans lequel lesdits moyens à porte logique sont une porte OU exclusif (42), la sortie de ladite porte OU exclusif (42) étant reliée à un premier amplificateur (38); la sortie de courant directionnel respectif (α, β) étant également reliée à un second amplificateur (40); lesdits premier et second amplificateurs (38, 40) étant reliés aux extrémités respectives du circuit X ou Y associé.
